(19) Europäisches Patentamt

European Patent Office

Office européen des brevets

(11) EP 0 711 047 B1

(12) **EUROPÄISCHE PATENTSCHRIFT**

(45) Veröffentlichungstag und Bekanntmachung des Hinweises auf die Patenterteilung:
**02.01.2002 Patentblatt 2002/01**

(51) Int Cl.⁷: **H04J 3/06**

(21) Anmeldenummer: **95116502.6**

(22) Anmeldetag: **19.10.1995**

(54) **Pufferspeichereinrichtung zur Taktanpassung zwischen einem Eingangs- und einem Ausgangsdatensignal**

Buffer memory circuit for clock adaptation between an input and an output data signal

Circuit de mémoire tampon pour adapter l'horloge entre un signal de données d'entrée et un signal de données de sortie

(84) Benannte Vertragsstaaten:
**BE CH DE FR GB IT LI**

(30) Priorität: **02.11.1994 DE 4439126**

(43) Veröffentlichungstag der Anmeldung:
**08.05.1996 Patentblatt 1996/19**

(73) Patentinhaber: **SIEMENS AKTIENGESELLSCHAFT**
**80333 München (DE)**

(72) Erfinder:
- **Maurer, Erich, Dipl.-Ing.**
  **A-1220 Wien (AT)**
- **Marik, Wolfgang**
  **A-1100 Wien (AT)**

(56) Entgegenhaltungen:
**EP-A- 0 379 279**

- **P. KARL, R.V. DECKER: "Digitale Ubertragungstechnik " , SEITEN 14- 16 ; VERLAG G. SCHENCK XP002057877 * Seite 14, Absatz 1.4.4.2.5 - Seite 16 ***

**Beschreibung**

Die Erfindung betrifft eine Pufferspeichereinrichtung nach dem Oberbegriff des Patentanspruchs 1.

Zwischenspeicherung Pufferspeicher werden für die Taktanpassung zwischen Eingangs- und Ausgangsdatensignalen verwendet. Die Daten werden beispielsweise mit einem Lückentakt in dem Pufferspeicher eingeschrieben und mit einem kontinuierlichen Takt ausgelesen. Eine solche Taktanpassung ist aus "Digitale Übertragungstechnik" von Peter Karl, R.V. Decker's Verlag G.Schenck unter 1.4.4.2.5 beschrieben. Ebenso ist eine Taktanpassung zwischen einem kontinuierlichen Eingabetakt und einem lückenbehafteten Ausgabetakt bekannt. Für bestimmte Anwendungsfälle sind jedoch Zusatzbedingungen einzuhalten. So wird beispielsweise für die Durchschaltung eines Datensignals über ein Koppelfeld eine konstante Laufzeit zwischen einem Abrufsignal und den erwarteten Daten gefordert, um diese an einer bestimmten Stelle des Koppelfeld-Pulsrahmens einordnen zu können. Hierzu wird einem Datenzwischenspeicher das Abrufsignal zur Taktanpassung über einen ersten Pufferspeicher zugeführt und die ausgegebenen Daten wiederum zur Taktanpassung über einen zweiten Pufferspeicher ausgegeben. Durch die beiden Taktanpassungen ergeben sich jedoch Schwankungen der Durchlaufzeit bis zu 2 Ausgabetakten.

Aufgabe der Erfindung ist es eine Pufferspeichereinrichtung anzugeben, bei der die Summe der Durchlaufzeiten durch beide Pufferspeicher konstant ist.

Diese Aufgabe wird durch eine Pufferspeichereinrichtung nach Anspruch 1 gelöst.

Vorteilhafte Weiterbildungen sind in den Unteransprüchen angegeben.

Wesentlich bei der Erfindung ist die Verwendung von gemeinsamen Adressenzählern für beide Pufferspeicher. Hierdurch wird automatisch die gesamte Durchlaufzeit durch beide Speicher konstant gehalten.

Die Pufferspeichereinrichtung kann mit einem kontinuierlichen oder auch mit einem lückenbehafteten Ausgabetakt betrieben werden. Sind die mittleren Taktfrequenzen von Ein- und Ausgabetakt gleich, dann kann auf eine Phasennachregelung verzichtet werden.

Ein Ausführungsbeispiel der Pufferspeichereinrichtung wird anhand von Figuren näher erläutert.

Es zeigen:

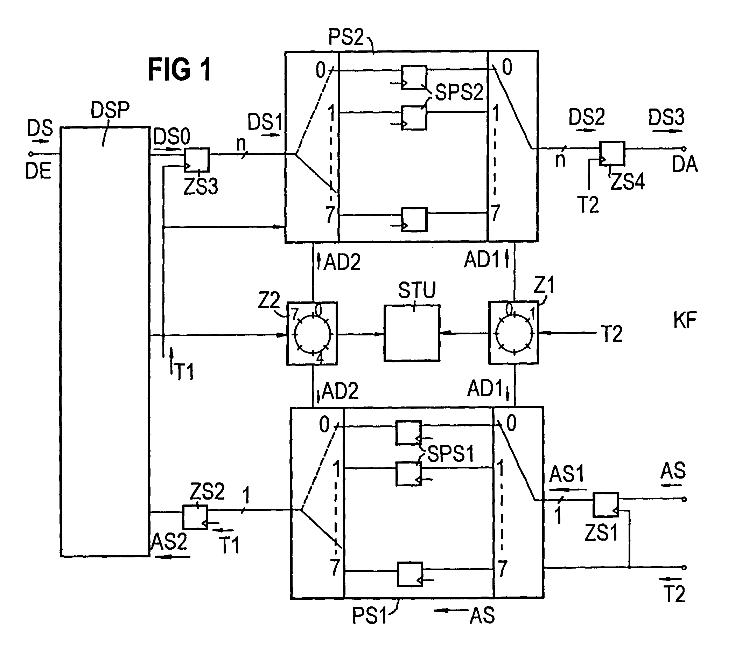

Fig. 1  ein Prinzipschaltbild der Puffereinspeicherung und

Fig. 2  ein Zeitdiagramm zur Erläuterung der Funktion.

Die Pufferspeichereinrichtung enthält einen ersten Pufferspeicher PS1, dem - in diesem Ausführungsbeispiel - über einen ersten Zwischenspeicher ZS1 ein synchronisiertes Abrufsignal AS1 zugeführt wird, das durch Abtakten eines asynchronen Abrufsignals AS mit einem systeminternen Ausgabetakt T2 erzeugt wurde. Dieses Signal wird nach der Zwischenspeicherung in Speicherstufen SPS1 vom Ausgang des ersten Pufferspeichers PS1 über einen zweiten Zwischenspeicher ZS2 an einen Datenspeicher DSP weitergegeben. Dieser speichert (und verarbeitet) jeweils mehrere Bytes eines Datensignals DS, das ihm über einen Dateneingang DE zugeführt wurde, und gibt nach Erhalt des Abrufsignals, eines Impulses, - eventuell erst nach einer konstanten internen Laufzeit - über einen dritten Zwischenspeicher SZ3 die abgerufenen Daten DS0 an einen zweiten Pufferspeicher PS2 weiter. Der zweite und der dritte Zwischenspeicher können auch Teil des Datenspeichers DSP sein.

Die durch Abtasten mit dem Eingabetakt synchronisierten Daten DS1 werden zunächst in den Speicherstufen SP2 zwischengespeichert und später über einen vierten Zwischenspeicher ZS4 als Datensignal DS2 am Datenausgang DA abgegeben. Die Ziffern bei den Bezugszeichen des Datensignals dienen zur zeitlichen Unterscheidung.

In dem Ausführungsbeispiel wird eine byteweise (n = 8) Verarbeitung angenommen. Die Daten können selbstverständlich seriell oder parallel beispielsweise an ein Koppelfeld KF abgegeben werden, dessen Steuerung die Abrufsignale abgibt.

Die Steuerung der Eingabe des ersten Pufferspeichers PS1 und die der Ausgabe des zweiten Pufferspeichers PS2 erfolgt über einen ersten Adreßzähler Z1, der einen Adressenumfang Z1 = 0, 1, ...., 7, also N = 8 hat und mit dem Ausgabetakt T2 arbeitet. Mit diesem Takt erfolgt auch die Speicherung in den Speicherstufen SPS1. Die Ansteuerung der Speicherstufen zur Eingabe ist jeweils durch einen Demultiplexer symbolisch dargestellt, ebenso die Ausgabe der Speicherinhalte aus den Pufferspeichern durch jeweils einen Multiplexer.

Die Ausgabesteuerung des ersten Pufferspeichers PS1 und die Eingabesteuerung des zweiten Pufferspeichers PS2 erfolgt von einem zweiten Adressenzähler Z2, der denselben Adressenumfang wie der erste Adressenzähler und mit dem Eingabetakt T1 arbeitet. Dieser Takt liegt auch an dem zweiten Zwischenspeicher ZS2 und dem dritten Zwischenspeicher ZS3 an und bestimmt die Zeitpunkte der Einspeicherung in die Speicherstufen SPS2 des zweiten Pufferspeichers.

Bei byteweiser Verarbeitung enthalten die dargestellten Speicherstufe SPS2 und die Zwischenspeicher ZS3 und ZS4 jeweils acht binäre Speicherzellen.

Die Durchlaufzeit eines Speichers entspricht dem Abstand zwischen der Eingabeadresse und der Ausgabeadresse. Die Erfindung beruht nun auf dem Gedanken, daß die Summe der Durchlaufzeiten des ersten und des zweiten Pufferspeichers konstant ist, wenn jeweils dieselbe Adresse als Eingabeadresse des einen Pufferspeichers und als Ausgabeadresse des anderen Pufferspeichers verwendet wird.

Die Durchlaufzeit entspricht bei Modulo-N-Subtraktion den Adressendifferenzen:

$$(AD1 - AD2) + (AD2 - AD1) = N$$

Bei der Verwendung von Lückentakten kann es hiervon zu Abweichungen kommen.

Eine Steuerung und Überwachungsschaltung STU kann aufgrund eines Vergleichs der Zählerstände die Frequenz eines Oszillators steuern, der den Ausgabetakt T2 erzeugt. Diese Frequenzregelung kann bei synchronen Takten und auch dann entfallen, wenn einer dieser Takte, z.B. T2, zwar ein Lückentakt ist, jedoch exakt die gleiche mittlere Taktanzahl je Zeiteinheit aufweist.

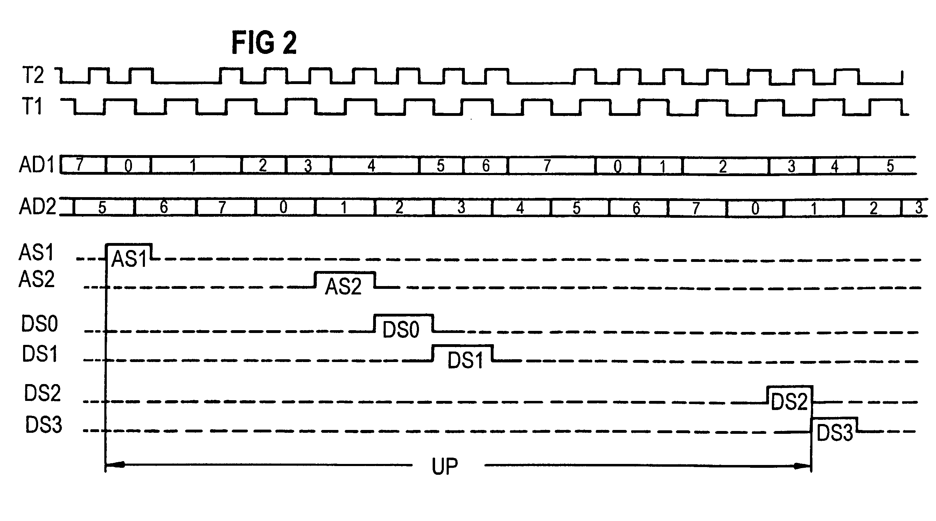

Im Ausführungsbeispiel wird angenommen und im Zeitdiagramm der Figur 2 verdeutlicht, daß das Verhältnis der Taktfrequenz des Eingabetaktes T1 zu der Taktfrequenz eines nicht dargestellten erzeugten Taktes 3:4 ist. Durch Ausblenden jedes vierten Taktes aus diesem Taktsignal (oder durch eine entsprechende Steuerung über Enable-Eingänge) wird ein lückenbehafteter Ausgabetakt T2 mit der mittleren Frequenz des Eingabetaktes T1 erzeugt. Mit diesem Lückentakt wird das synchrone Abrufsignal AS1 unter der Eingabeadresse AD1, z.B. = 0, in den ersten Pufferspeicher PS1 übernommen und mit dem Eingabetakt T1 - die Bezeichnung Eingabetakt bezieht sich auf die Eingabe des Datensignals DS - als verzögertes Abrufsignal ausgegeben, wenn die Ausgabeadresse AD2 ebenfalls 0 ist. Das Abrufsignal AS2 bewirkt die Ausgabe beispielsweise eines bestimmten Bytes des Datensignals DS0 aus dem Datenspeicher DSP, das zeitlich verzögert als Datensignal DS1 am Eingang des zweiten Pufferspeichers PS2 anliegt. Es wird unter der Eingabeadresse AD2 = 2 in den Pufferspeicher übernommen und an dessen Ausgang als Datensignal DS2 abgegeben, sobald die Ausgabeadresse AD1 ebenfalls 2 ist, und zum Ende des Intervalls mit dem Ausgabetakt T2 ausgegeben wird. Die Bezugzeichen DS0 bis DS3 können also als verschiedene Zeitpunkte interpretiert werden, zu denen dasselbe Datenbyte an den verschiedenen Schaltungspunkten anliegt. In das Zeitdiagramm wurde nur ein einziger Abrufimpuls und ein durch diesen Abrufimpuls ausgegebenes Datenbyte eingezeichnet, um die Funktion zu verdeutlichen.

Durch den lückenhaften Ausgabetakt kann es zu zeitlichen Schwankungen der Gesamtlauffzeit kommen, die unbeachtlich sind, wenn es nur auf die Anzahl der Ausgabeimpulse ankommt. Diese Schwankungen können vermieden werden, indem die Gesamtlaufzeit zwischen dem Takt T2, mit dem das Abrufsignal AS in den ersten Zwischenspeicher übernommen wird, und dem Takt T2 mit dem das abgerufene Datensignal vom Ausgang des vierten Zwischenspeichers in den vierten Zwischenspeicher ZS4, der Teil des Koppelfeldes ist, so gewählt wird, daß sie einem Vielfachen einer gemeinsamen Überperiode UP des Eingabetaktes Z1 und des Ausgabetaktes T2 entspricht.

Selbstverständlich kann die Pufferspeichereinrichtung auch mit einem kontinuierlichen Eingabetakt anstelle eines Lückentaktes betrieben werden; ebenso sind die Zwischenspeicher ZS nicht unbedingt erforderlich oder können Teil des Datenspeichers DSP oder des Koppelfeldes KF sein.

## Patentansprüche

1. Pufferspeichereinrichtung zur Taktanpassung zwischen einem Eingangs- und einem Ausgangsdatensignal, bei der vorgesehen ist:

   ein erster Pufferspeicher (PS1), dem ein Abrufsignal (AS1) zugeführt wird und der ein verzögertes Abrufsignal (AS2) abgibt,
   ein zweiter Pufferspeicher (PS2), dem ein abgerufene Datensignal (DS1) zugeführt wird und der ein verzögertes Datensignal (DS2) abgibt,
   ein erster Adressenzähler (Z1), der mit einem Ausgabetakt (T2) gesteuert wird und die Eingabeadresse (AD1) des ersten Pufferspeichers (PS1) sowie die Ausgabeadresse (AD1) des zweiten Pufferspeichers (PS2) bestimmt, und
   ein zweiter Adressenzähler (Z2), der mit einem Eingabetakt (T1) gesteuert wird und die Ausgabeadresse (AD2) des ersten Pufferspeichers (PS1) sowie die Eingabeadresse (AD2) des zweiten Pufferspeichers (PS2) bestimmt.

2. Pufferspeichereinrichtung nach Anspruch 1,
   **dadurch gekennzeichnet,**
   **daß** der erste Adressenzähler (Z1) von einem Lückentakt (T2) gesteuert wird.

3. Pufferspeichereinrichtung nach Anspruch 1 oder 2,
   **dadurch gekennzeichnet,**
   **daß** den ersten Pufferspeicher (PS1) ein erster Zwischenspeicher (ZS1) vorgeschaltet und dem zweiten Pufferspeicher (PS2) ein weiterer Zwischenspeicher (ZS4) nachgeschaltet ist.

4. Pufferspeichereinrichtung nach einem der vorhergehenden Ansprüche,
   **dadurch gekennzeichnet,**
   **daß** die Gesamtverzögerung so gewählt ist, daß sie einer gemeinsamen Überperiode (UP) des Eingabetaktes (T1) und des lückenbehafteten Ausgabetaktes (T2) oder einem Vielfachen hiervon entspricht.

## Claims

1. Buffer store device for timing alignment between an input data signal and an output data signal, which is provided with the following:

a first buffer store (PS1), to which a retrieval signal (AS1) is supplied and which outputs a delayed retrieval signal (AS2),
a second buffer store (PS2), to which a retrieved data signal (DS1) is supplied and which outputs a delayed data signal (DS2),
a first address counter (Z1), which is controlled by means of an output clock (T2) and determines the input address (AD1) of the first buffer store (PS1) and the output address (AD1) of the second buffer store (PS2), and
a second address counter (Z2), which is controlled by means of an input clock (T1) and determines the output address (AD2) of the first buffer store (PS1) and the input address (AD2) of the second buffer store (PS2).

2. Buffer store device according to Claim 1, **characterized in that** the first address counter (Z1) is controlled by a discontinuous clock (T2).

3. Buffer store device according to Claim 1 or 2, **characterized in that** the first buffer store (PS1) has a first temporary store (ZS1) connected upstream, and the second buffer store (PS2) has another temporary store (ZS4) connected downstream.

4. Buffer store device according to one of the preceding claims, **characterized in that** the total delay is chosen such that it corresponds to a common overperiod (UP) of the input clock (T1) and the discontinuous output clock (T2) or to a multiple thereof.

**Revendications**

1. Dispositif de mémoire tampon pour l'adaptation de cadence entre un signal de données d'entrée et un signal de données de sortie, dans lequel il est prévu :

une première mémoire (PS1) tampon à laquelle un signal (AS1) d'appel est envoyé et qui fournit un signal (AS2) d'appel retardé,
une deuxième mémoire (PS2) tampon à laquelle un signal (DS1) de données appelé est envoyé et qui fournit un signal (DS2) de donnée retardé,
un premier compteur (Z1) d'adresse qui est commandé à une cadence (T2) de sortie et qui détermine l'adresse (AD1) de la première mémoire (PS1) tampon ainsi que l'adresse (AD1) de sortie de la deuxième mémoire (PS2) tampon, et
un deuxième compteur (Z2) d'adresse qui est commandé à une cadence (T1) d'entrée et qui détermine l'adresse (AD2) de sortie de la première mémoire (PS1) tampon ainsi que l'adresse (AD2) d'entrée de la deuxième mémoire (PS2) tampon.

2. Dispositif de mémoire tampon suivant la revendication 1, **caractérisé en ce que** le premier compteur (Z1) d'adresse est commandé par une cadence (T2) à intervalle.

3. Dispositif de mémoire tampon suivant la revendication 1 ou 2, **caractérisé en ce que** la première mémoire (PS1) tampon est montée en amont d'une première mémoire (ZS1) intermédiaire et **en ce qu'**une mémoire (ZS4) intermédiaire supplémentaire est montée en aval de la deuxième mémoire (PS2) tampon.

4. Dispositif de mémoire tampon suivant l'une des revendications précédentes, **caractérisé en ce que** le retard total est choisi de manière à correspondre à une sur-période (UP) commune de la cadence (T1) d'entrée et de la cadence (T2) de sortie affectée d'intervalle ou à un multiple de cette sur-période commune.

FIG 1

## FIG 2

EP 0 711 047 B1